Europäisches Patentamt

European Patent Office

Office européen des brevets

(19)

(11) **EP 1 349 199 A1**

(12) **EUROPÄISCHE PATENTANMELDUNG**

(43) Veröffentlichungstag:
01.10.2003 Patentblatt 2003/40

(51) Int Cl.⁷: **H01L 21/00**

(21) Anmeldenummer: 02405250.8

(22) Anmeldetag: 28.03.2002

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **Esec Trading S.A.**
**6330 Cham (CH)**

(72) Erfinder:
• **Mannhart, Eugen**
**6330 Cham (CH)**
• **Schubiger, Reto**
**6030 Ebikon (CH)**

(74) Vertreter: **Falk, Urs, Dr.**
**Patentanwaltsbüro Dr. Urs Falk,**
**Eichholzweg 9A**
**6312 Steinhausen (CH)**

(54) **Einrichtung für die Montage von Halbleiterchips**

(57) Eine Einrichtung für die Montage von Halbleiterchips umfasst eine Beladestation (1) für die Bereitstellung von Substraten (2), eine erste Transportvorrichtung (4) und eine zweite Transportvorrichtung (5). Die erste Transportvorrichtung (4) entnimmt ein Substrat (2) nach dem andern aus der Beladestation (1) und übergibt es an die zweite Transportvorrichtung (5), die die Substrate (2) taktweise zu einer Dispens- oder Lotstation (6) und zu einer Bondstation (7) transportiert. Ein Sensor (8) mit zwei im Abstand zueinander angeordneten Spulen (10, 11) ist derart angeordnet, dass ein Ende des von der ersten Transportvorrichtung (4) transportierten Substrats (2) einen zwischen den beiden Spulen (10, 11) gebildeten Zwischenraum durchfährt. Die von den Spulen (10, 11) gelieferten Signale werden zu einem Summensignal addiert. Aus dem Summensignal wird ein Steuersignal ermittelt, das angibt, ob die erste Transportvorrichtung (4) das Substrat (2) an die zweite Transportvorrichtung (5) übergeben soll oder nicht.

Fig. 1

**Beschreibung**

Die Erfindung betrifft eine Einrichtung für die Montage von Halbleiterchips der im Oberbegriff des Anspruchs 1 genannten Art.

Bei sehr vielen Anwendungen werden Halbleiterchips auf ein metallisches Substrat, ein sogenanntes Leadframe, montiert. Die Leadframes werden dabei in Magazinen oder auf einem Stapel bereitgestellt, wo sie von einem Roboter entnommen und der Transportvorrichtung eines Montageautomaten, eines sogenannten Die Bonders, zugeführt werden, die die Leadframes nacheinander zu einer Dispensstation, wo Klebstoff oder Lot aufgetragen wird, und zu einer Bondstation, wo der Halbleiterchip aufgebracht wird, transportiert.

Wenn die Leadframes auf einem Stapel bereitgestellt werden, kommt es bei der Entnahme immer wieder vor, dass zwei Leadframes aneinander haften, so dass anstelle eines einzigen Leadframes zwei Leadframes entnommen und der Transportvorrichtung übergeben werden. Um solche Fehler zu erkennen, wird die Dicke des an die Transportvorrichtung übergebenen Leadframes bestimmt. Dies erfolgt üblicherweise auf mechanische Weise, in der Regel mittels einer Abtastnadel. Wenn die gemessene Dicke einen vorbestimmten Maximalwert überschreitet, bedeutet dies, dass zwei Leadframes entnommen wurden. Demzufolge wird der Roboter angewiesen, die Leadframes wieder von der Transportvorrichtung zu entnehmen und einem Abfallbehälter zuzuführen. Diese Art der Kontrolle hat den Nachteil, dass der Fehler erst spät erkannt wird. Es braucht Zeit, um zwei aneinander haftende Leadframes von der Transportvorrichtung zu entnehmen und ein neues Leadframe zuzuführen, was den Durchsatz vermindert.

Der Erfindung liegt die Aufgabe zugrunde, den Ablauf der Entnahme und Kontrolle der Leadframes zu verbessern.

Die Erfindung besteht in den im Anspruch 1 angegebenen Merkmalen. Vorteilhafte Ausgestaltungen ergeben sich aus den abhängigen Ansprüchen.

Zur Bestimmung der Dicke des aufgenommenen Substrates bzw. der aufgenommenen Substrate wird erfindungsgemäss ein induktiver Sensor eingesetzt. Die Erfindung macht dabei Gebrauch von der induktiven Abstandsmessung, bei der der ohmsche Widerstand und/oder die Induktivität einer mit einem Wechselstrom beaufschlagten Spule ändert, wenn ein metallischer Gegenstand in ihrem magnetischen Nahfeld bewegt wird. Bei der Erfindung umfasst der Sensor zwei im Abstand angeordnete Spulen. Die Dicke des aufgenommenen Substrates bzw. der aufgenommenen Substrate wird unmittelbar nach der Entnahme aus der Beladestation gemessen. Dabei wird ein Ende des Substrats durch den zwischen den beiden Spulen gebildeten Zwischenraum hindurchtransportiert. Als Spulen dienen vorzugsweise Flachspulen, die den über ihre Fläche gemittelten Abstand zu der der Flachspule zugewandten Oberfläche des Substrats messen. Die beiden Spulen werden unabhängig voneinander betrieben, wobei jede Spule gleichzeitig als Erreger- wie als Empfängerspule dient. Die Signale der beiden Spulen werden dann addiert und das Summensignal ausgewertet. Falls die Auswertung als Resultat ergibt, dass nur ein einziges Substrat aufgenommen wurde, wird das Substrat an eine Transportvorrichtung übergeben, die das Substrat taktweise zu einer Dispens- bzw. Lotstation, wo Klebstoff bzw. Lot aufgetragen wird, und zu einer Bondstation, wo der Halbleiterchip aufgebracht wird, transportiert. Falls die Auswertung ergibt, dass mehr als ein Substrat aufgenommen wurde, dann werden die Substrate an einen Abfallbehälter übergeben.

Jede einzelne Flachspule wird mit einem hochfrequenten Wechselstrom beaufschlagt und erzeugt somit ein hochfrequentes Magnetfeld. Die Frequenz f des Wechselstroms ist so hoch gewählt, dass die Eindringtiefe des Magnetfeldes in die zugewandte metallische Oberfläche des Substrats deutlich geringer ist als deren Dicke. Die Eindringtiefe $\delta$ ist bestimmt durch den Skineffekt und lässt sich gemäss der Gleichung

$$\delta \approx \sqrt{\frac{1}{\pi\mu\sigma f}}$$

berechnen, wobei $\mu$ die magnetische Permeabilität und $\sigma$ die elektrische Leitfähigkeit der metallischen Oberfläche bezeichnen. Eine hohe Frequenz f drängt sich auch aus elektrotechnischen Gründen auf: Da die Induktivität L der Flachspule in der Regel sehr gering ist und die Flachspule mit einem Kondensator einen Schwingkreis bildet, ergibt sich nur dann ein vernünftiger Wert für die Kapazität C des Kondensators, wenn die Resonanzfrequenz des Schwingkreises sehr gross ist. In der Praxis hat sich eine Frequenz f in der Grössenordnung von 10 MHz bewährt. Das Ausgangssignal der Flachspule ist z.B. die Resonanzfrequenz des aus der Flachspule und einem Kondensator gebildeten Schwingkreises, oder die Amplitude der an der Flachspule anliegenden Wechselspannung, oder die Phasenlage der an der Flachspule anliegenden Wechselspannung, oder ein anderes von der Flachspule direkt abgeleitetes Signal. Die Flachspule dient somit einerseits zur Erzeugung eines magnetischen Wechselfeldes als auch zur Erfassung der Wirkung, den die der Flachspule zugewandte Oberfläche des Substrats auf das Magnetfeld ausübt.

Die Erfindung lässt sich auch verwenden, um die Umstellung eines Die Bonders auf ein neues Produkt zu vereinfachen. Der Die Bonder kommuniziert dann mit einer Datenbank mit Datensätzen, die je ein auf dem Die Bonder zu verarbeitendes Produkt kennzeichnen. Jeder Datensatz weist charakteristische Daten auf, die das zum Produkt gehörende Substrat charakterisieren, wobei diese Daten in einer Lernphase mittels des Sensors erfasst werden. Zudem weist jeder Datensatz Maschinenparameter auf, die für die Verarbeitung des Produkts einzustellen sind. Der Die Bonder ist nun eingerichtet, beim Wechsel von einem Produkt auf ein neues Produkt, von dem in der Datenbank bereits ein Datensatz vorhanden ist, in einem Vorbereitungsmodus

> a) die charakteristischen Daten eines zum neuen Produkt gehörenden Substrats mittels des Sensors zu erfassen,
> b) denjenigen Datensatz zu bestimmen, dessen charakteristische Daten den für das soeben ausgemessene Substrat ermittelten charakteristischen Daten entsprechen, und
> c) die Maschinenparameter des ermittelten Datensatzes zu laden.

Nun kann der Produktionsbetrieb aufgenommen werden.

Nachfolgend werden Ausführungsbeispiele der Erfindung anhand der Zeichnung näher erläutert.

Es zeigen:

Fig. 1    eine Einrichtung für die Montage von Halbleiterchips mit einem Sensor,
Fig. 2    den Sensor im Schnitt entlang der Linie I-I der Fig. 1,
Fig. 3    eine Spule des Sensors,
Fig. 4    den zeitlichen Verlauf des Signals des Sensors, und
Fig. 5    ein Beispiel mit mehreren Sensoren.

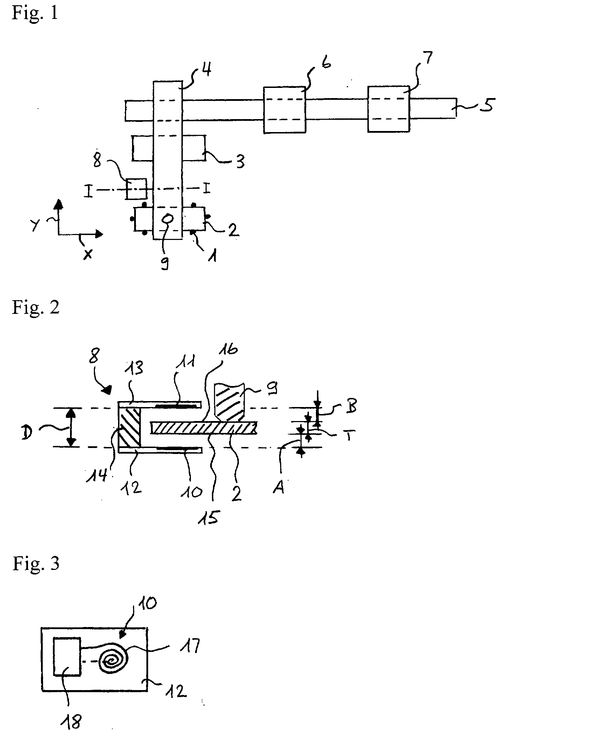

Die Fig. 1 zeigt schematisch und in Aufsicht eine Einrichtung für die Montage von Halbleiterchips, einen sogenannten Die Bonder, soweit es für das Verständnis der Erfindung erforderlich ist. Der Die Bonder umfasst eine Beladestation 1, wo mit Halbleiterchips zu bestückende Substrate 2 bereitgestellt werden. Im Beispiel sind die Substrate 2 übereinander gestapelt. Der Die Bonder umfasst weiter einen Abfallbehälter 3, eine erste und eine zweite Transportvorrichtung 4 und 5, eine Dispens- oder Lotstation 6, eine Bondstation 7, sowie einen Sensor 8 für die Bestimmung der Anzahl der von der Beladestation 1 entnommenen Substrate 2. Die erste Transportvorrichtung 4 weist einen in einer y-Richtung hin und her bewegbaren Greifer 9 auf, der ein Substrat 2 nach dem andern aus der Beladestation 1 entnimmt, in y-Richtung am Sensor 8 vorbei transportiert und entweder dem Abfallbehälter 3 oder der zweiten Transportvorrichtung 5 übergibt. Die zweite Transportvorrichtung 5 transportiert die Substrate 2 taktweise zur Dispens- oder Lotstation 6, wo eine Portion Klebstoff bzw. Lot aufgebracht wird, und zur Bondstation 7, wo ein Halbleiterchip aufgebracht wird.

Die Fig. 2 zeigt den Sensor 8 im Schnitt entlang der Linie I-I der Fig. 1. Der Sensor 8 weist zwei im Abstand D zueinander angeordnete Spulen 10 und 11 auf. Die Spulen 10 und 11 sind vorzugsweise auf herkömmlichen Leiterplatten 12 bzw. 13 aus Leiterbahnen gebildete Flachspulen. Die Leiterplatten 12 und 13 sind durch einen Distanzhalter 14 getrennt. Beim Transport von der Beladestation 1 (Fig. 1) zur zweiten Transportvorrichtung 5 durchfährt ein Ende des Substrates 2 den zwischen den beiden Spulen 10 und 11 bestehenden Zwischenraum. Die erste Spule 10 misst den Abstand A von der Spule 10 zur Unterseite 15 des Substrats 2. Die zweite Spule 11 misst den Abstand B von der Spule 11 zur Oberseite 16 des Substrats 2. Die Dicke T des Substrates 2 ergibt sich dann zu:

$$T = D - A - B = D - (A + B).$$

Die Fig. 3 zeigt die Spule 10 des Sensors 8 in Aufsicht. Eine spiralförmig verlaufende Leiterbahn 17 bildet die Windungen der als Flachspule ausgebildeten Spule 10. Der Durchmesser der Spule 10 beträgt typischerweise etwa 1 bis 2 cm. Die Windungen der Flachspule können aber auch eine beliebige andere Form aufweisen, z.B. rechteckförmig oder dreieckförmig sein. Die Leiterplatte 12 enthält auch eine elektronische Schaltung 18 zum Betrieb der Spule 10 und zur Auswertung des von der Spule 10 gelieferten Messsignals. Der Betrieb einer solchen Spule 10 zur Erzeugung eines Signals, das proportional ist zum Abstand von der Spule zu einer metallischen Fläche, ist an sich bekannt und wurde bereits weiter oben erläutert. Analog enthält die zweite Leiterplatte 13 (Fig. 2) eine elektronische Schaltung zum Betrieb der Spule 11. Das von der ersten Spule 10 erhaltene Messsignal wird im folgenden mit $U_A$, das von der zweiten Spule 11 erhaltene Messsignal wird mit $U_B$ bezeichnet.

Als Substrate 2 kommen sowohl metallische Substrate, sogenannte Leadframes, als auch Substrate 2 aus Kunststoff, beispielsweise sogenannte BGA's®, zur Anwendung. Die Kunststoffsubstrate enthalten sowohl auf ihrer Unterseite als auch auf ihrer Oberseite metallische Strukturen. Auch Leadframes sind strukturiert. Die Form der Strukturen beeinflusst die Messsignale $U_A$ und $U_B$ der beiden Spulen 10 bzw. 11. Da der Durchmesser der Spulen 10, 11 wesentlich grösser als die durch die metallischen Strukturen gebildeten Linien und Flächen ist, messen die beiden Spulen 10, 11 nicht direkt den Abstand A zur Unterseite 15 des Substrats 2 bzw. den Abstand B zur Oberseite 16 des Substrats 2. Trotzdem lassen sich aus den beiden Messsignalen $U_A$ und $U_B$ diverse Informationen extrahieren.

Beim Transport kann das in den Zwischenraum des Sensors 8 hineinragende Ende des Substrates 2 flattern, so dass auch die Abstände A und B "flattern". Die Summe der Abstände A+B bleibt hingegen konstant. Die beiden Messsignale $U_A$ und $U_B$ werden deshalb mit Vorteil addiert zu einem Signal $U_S = U_A + U_B$.

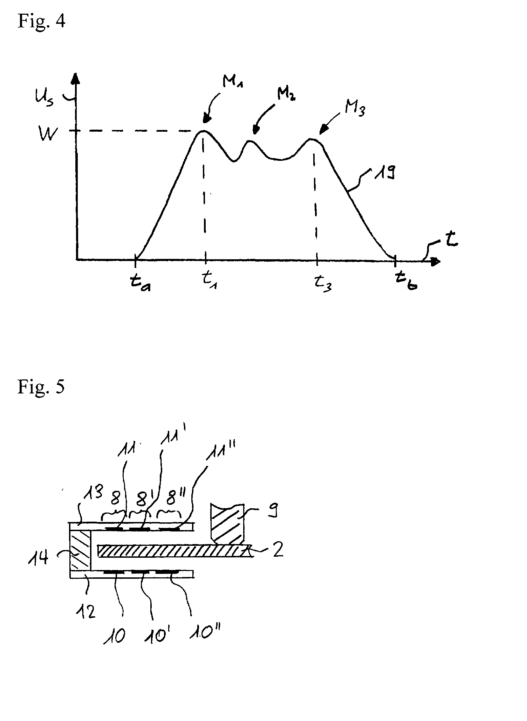

Die Fig. 4 zeigt mit ausgezogener Linie 19 den zeitlichen Verlauf des Signal $U_S$, wie er typischerweise vorkommt, wenn das Ende des Substrates 2, wie in der Fig. 2 dargestellt ist, zwischen den beiden Spulen 10 und 11 hindurch transportiert wird. Das Signal $U_S$ weist mehrere lokale Maxima auf, die durch lokale Minima getrennt sind. Im Beispiel hat es drei lokale Maxima $M_1$, $M_2$ und $M_3$. Das Maximum $M_1$ ist grösser als die beiden anderen Maxima $M_2$ und $M_3$ und somit ein globales Maximum. Wenn zwei Substrate aneinander kleben und zusammen durch den Sensor 8 transportiert werden, dann ändert sich das Signal $U_S$.

In einer Lernphase wird ein einziges Substrat 2 durch den Sensor 8 transportiert und aus dem Signal $U_S$ ein Referenzwert $W_{Ref}$ ermittelt. Im Produktionsbetrieb des Die Bonders wird aus dem Signal $U_S$ auf die gleiche Art ein Wert W ermittelt. Aus dem Absolutbetrag der Differenz $| W - W_{Ref} |$ wird ein Steuersignal ermittelt, das angibt, ob die erste Transportvorrichtung bzw. der Greifer 9 das aufgenommene Substrat 2 an die zweite Transportvorrichtung 5 übergeben soll oder nicht. Wenn der Betrag $|W - W_{Ref}|$ kleiner als ein vorbestimmter Toleranzwert R ist, dann heisst das, dass der Greifer 9 nur ein Substrat 2 aufgenommen hat. Der Greifer 9 wird deshalb angewiesen, das Substrat 2 an die zweite Transportvorrichtung 5 zu übergeben. Wenn der Betrag $|W - W_{Ref}|$ hingegen grösser als der Toleranzwert R ist, dann heisst das, dass der Greifer 9 mehr als ein Substrat 2 aufgenommen hat. Der Greifer 9 wird deshalb angewiesen, die aufgenommenen Substrate 2 an den Abfallbehälter 3 zu übergeben. Im folgenden werden zwei Beispiele angegeben, wie die gewünschte Information aus dem Signal $U_S$ extrahiert werden kann.

Beispiel 1

Als Wert W wird der Wert des globalen Maximums $M_1$ ermittelt. Dies ist in der Fig. 4 dargestellt.

Beispiel 2

Als Wert W dient das über die Zeit t integrierte Signal $U_S(t)$:

$$W = \int_{t_a}^{t_b} U_S(t)dt \,, \tag{1}$$

wobei die Zeitpunkte $t_a$ und $t_b$ den Eintritt des Substrates 2 in den Empfindlichkeitsbereich bzw. den Austritt aus dem Empfindlichkeitsbereich des Sensors 8 bezeichnen.

Wenn das Substrat 2 bezüglich seiner Längsachse nicht symmetrisch ist, dann ist auch der zeitliche Verlauf des Signals $U_S$ nicht symmetrisch. Mit einer weiteren Analyse des Signals $U_S$ lässt sich deshalb ermitteln, ob die Substrate 2 in der Beladestation 1 in der richtigen Orientierung bereit liegen. Im Beispiel der Fig. 4 tritt das globale Maximum $M_1$ zur Zeit $t_1$ vor dem lokalen Maximum $M_3$ zur Zeit $t_3$ auf. Wenn also bei der Auswertung des Signals $U_S$ festgestellt wird, dass das lokale Maximum $M_3$ vor dem globalen Maximum $M_1$ auftritt, d.h. dass $t_3 < t_1$ ist, dann heisst dies, dass die Substrate 2 in der Beladestation 1 in einer falschen Lage bereitgestellt wurden. Demzufolge wird der Produktionsbetrieb des Die Bonders gestoppt und ein Alarm mit einer entsprechenden Meldung erzeugt.

Es kommt im Produktionsbetrieb auch vor, dass in der Beladestation 1 irrtümlich Substrate eines anderen Typs bereitgestellt werden. Mit dem Sensor 8 lässt sich dies erkennen. Wenn der Betrag $|W - W_{Ref}|$ grösser als der Toleranzwert R ist, dann wurde dies im oben beschriebenen Beispiel dahingehend interpretiert, dass der Greifer 9 mehr als ein Substrat aufgenommen hat. Die Analyse kann nun aber auf verschiedene Arten weiter verfeinert werden:

A) Wenn sich für aufeinanderfolgende Messungen, beispielsweise zwei oder drei Messungen, ergibt, dass der Betrag $|W - W_{Ref}|$ grösser als der Toleranzwert R ist, dann kann dies auch bedeuten, dass nicht zwei Substrate aufgenommen wurden, sondern dass in der Beladestation 1 irrtümlich Substrate eines anderen Typs bereit liegen. Demzufolge wird der Produktionsbetrieb des Die Bonders gestoppt und ein Alarm mit einer entsprechenden Meldung erzeugt.

B) Wenn der Betrag $|W - W_{Ref} |$ grösser als ein zweiter Toleranzwert $R_2$ ist, wobei der Toleranzwert $R_2$ grösser als der Toleranzwert R ist, dann wird dies dahingehend interpretiert, dass in der Beladestation 1 irrtümlich Substrate eines anderen Typs bereit liegen. Demzufolge wird der Produktionsbetrieb des Die Bonders gestoppt und ein Alarm mit einer entsprechenden Meldung erzeugt.

C) Wenn der Betrag | W - W$_{Ref}$ | grösser als der Toleranzwert R ist, dann lässt sich unter Umständen auch aus dem Vorzeichen der Differenz W - W$_{Ref}$ ableiten, ob Substrate eines falschen Typs bereitgestellt werden.

Im Folgenden wird noch eine Weiterentwicklung der Erfindung erläutert, bei der es darum geht, das vom Sensor 8 gelieferte Signal U$_S$(t) zu verwenden, um den Die Bonder beim Umstellen auf ein anderes Produkt automatisch auf das neue Produkt einzustellen. Zu diesem Zweck weist der Die Bonder eine Datenbank auf, in der einerseits die für die Produktion des Produktes einzustellenden Maschinenparameter und andererseits Daten, die das zum Produkt gehörende Substrat charakterisieren, gespeichert sind. Diese charakteristischen Daten werden aus dem vom Sensor 8 gelieferten Signal U$_S$(t) gewonnen. Beispiele für solche charakteristischen Daten sind:

- der zeitliche Verlauf des Signals U$_S$(t), und/oder
- mindestens ein aus dem Signal U$_S$(t) abgeleiteter Wert wie z.B. der Wert des globalen Maximums M$_1$ oder der Wert des Integrals gemäss Gleichung (1), oder der Wert des lokalen Maximums M$_2$, etc.

Wenn auf dem Die Bonder ein Produkt P zum erstenmal verarbeitet werden soll, dann wird in einem Lernmodus ein zu diesem Produkt P gehöriges Substrat 2 von der ersten Transportvorrichtung 4 wie oben beschrieben durch den Zwischenraum zwischen den Spulen 10 und 11 des Sensors 8 transportiert. Aus dem vom Sensor 8 gelieferten Signal U$_S$(t) werden anschliessend die charakteristischen Daten ermittelt. Ebenso werden die für die Verarbeitung des Produkts P nötigen Maschinenparameter ermittelt. Alle diese Daten werden in der Datenbank als neuer, zum Produkt P gehöriger Datensatz gespeichert.

Wenn die Produktion auf ein anderes Produkt P$_2$ umgestellt wird, das auf dem Die Bonder bereits früher produziert wurde, dann können die in der Datenbank gespeicherten Datensätze benutzt werden, um den Die Bonder automatisch auf das Produkt P$_2$ einzustellen. Dies geschieht in einem Vorbereitungsmodus, in dem von der ersten Transportvorrichtung 4 ein zu diesem Produkt P$_2$ gehörendes Substrat durch den Sensor 8 transportiert und anschliessend aus dem Sensorsignal U$_S$(t) die charakteristischen Daten ermittelt werden. Dann wird derjenige Datensatz der Datenbank ermittelt, dessen charakteristische Daten den für das soeben transportierte Substrat 2 ermittelten charakteristischen Daten entsprechen. Dieser Datensatz enthält alle für die Verarbeitung des zum ausgemessenen Substrat gehörenden Produktes P$_2$ notwendigen Maschinenparameter. Der Die Bonder lädt nun diese Maschinenparameter und ist somit auf das neu zu produzierende Produkt P$_2$ eingestellt, so dass nun vom Vorbereitungsmodus in den Produktionsmodus gewechselt und die Produktion aufgenommen werden kann.

Damit alle diese Aufgaben zuverlässig durchgeführt werden können, ist es unter Umständen vorteilhaft, die Abmessungen des Sensors 8 zu verkleinern. Je kleiner die Abmessungen eines Sensors sind, um so grösser ist dessen räumliches Auflösungsvermögen. Je grösser das räumliche Auflösungsvermögen ist, desto eher können auch relativ kleine strukturelle Unterschiede zwischen verschiedenen Substrattypen zuverlässig detektiert werden.

Eine weitere Möglichkeit besteht darin, wie in der Fig. 5 gezeigt ist, mehrere, relativ kleine, ebenfalls aus je zwei Spulen bestehende, Sensoren 8 zu verwenden, die nebeneinander quer zur Transportrichtung der ersten Transportvorrichtung 4 angeordnet sind. Jeder dieser Sensoren 8 erfasst dann einen anderen Bereich des Substrats 2. Im Beispiel sind drei Sensoren 8, 8' und 8" dargestellt. Die zugehörigen Spulen sind mit den Bezugszeichen 10, 10' und 10" bzw. 11, 11' und 11" bezeichnet.

**Patentansprüche**

1. Einrichtung für die Montage von Halbleiterchips, mit einer Beladestation (1) für die Bereitstellung von Substraten (2), einer ersten Transportvorrichtung (4) und einer zweiten Transportvorrichtung (5), wobei die erste Transportvorrichtung (4) ein Substrat (2) nach dem andern aus der Beladestation (1) entnimmt und an die zweite Transportvorrichtung (5) übergibt, und wobei die zweite Transportvorrichtung (5) die Substrate (2) taktweise zu einer Dispens- oder Lotstation (6), wo eine Portion Klebstoff bzw. Lot aufgebracht wird, und zu einer Bondstation (7), wo ein Halbleiterchip aufgebracht wird, transportiert, **dadurch gekennzeichnet, dass** ein Sensor (8) mit zwei im Abstand zueinander angeordneten Spulen (10, 11) derart angeordnet ist, dass ein Ende des von der ersten Transportvorrichtung (4) transportierten Substrats (2) einen zwischen den beiden Spulen (10, 11) gebildeten Zwischenraum durchfährt, dass die von den Spulen (10, 11) gelieferten Signale zu einem Summensignal addiert werden und dass aus dem Summensignal ein Steuersignal ermittelt wird, das angibt, ob die erste Transportvorrichtung (4) das Substrat (2) an die zweite Transportvorrichtung (5) übergeben soll oder nicht.

2. Einrichtung nach Anspruch 1, **dadurch gekennzeichnet, dass** aus dem zeitlichen Verlauf des Summensignals eine Information ermittelt wird, die angibt, ob die Substrate (2) in der Beladestation (1) in der richtigen Orientierung bereitgestellt werden.

3. Einrichtung nach Anspruch 1 oder 2, wobei die Einrichtung mit einer Datenbank mit Datensätzen kommuniziert, die je ein auf der Einrichtung zu verarbeitendes Produkt kennzeichnen, **dadurch gekennzeichnet, dass** jeder Datensatz charakteristische Daten aufweist, die das zum Produkt gehörende Substrat (2) charakterisieren, wobei diese Daten in einer Lernphase mittels des Sensors (8) erfasst werden, dass jeder Datensatz Maschinenparameter aufweist, die für die Verarbeitung des Produkts einzustellen sind, und dass die Einrichtung eingerichtet ist, beim Wechsel von einem Produkt auf ein neues Produkt, von dem in der Datenbank bereits ein Datensatz vorhanden ist, in einem Vorbereitungsmodus

a) die charakteristischen Daten eines zum neuen Produkt gehörenden Substrats (2) mittels des Sensors (8) zu erfassen,
b) denjenigen Datensatz zu bestimmen, dessen charakteristische Daten den für das soeben ausgemessene Substrat (2) ermittelten charakteristischen Daten entsprechen, und
c) die Maschinenparameter des ermittelten Datensatzes zu laden.

Fig. 1

Fig. 2

Fig. 3

Fig. 4

Fig. 5

**Europäisches Patentamt**

# EUROPÄISCHER RECHERCHENBERICHT

Nummer der Anmeldung

EP 02 40 5250

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | PATENT ABSTRACTS OF JAPAN vol. 1995, no. 08, 29. September 1995 (1995-09-29) & JP 07 137886 A (TOSHIBA SEIKI KK), 30. Mai 1995 (1995-05-30) * Zusammenfassung * | 1 | H01L21/00 |
| A | PATENT ABSTRACTS OF JAPAN vol. 1999, no. 05, 31. Mai 1999 (1999-05-31) & JP 11 035152 A (MATSUSHITA ELECTRIC IND CO LTD), 9. Februar 1999 (1999-02-09) * Zusammenfassung * | 1 | |
| A | PATENT ABSTRACTS OF JAPAN vol. 009, no. 027 (E-294), 6. Februar 1985 (1985-02-06) & JP 59 172731 A (TOSHIBA KK), 29. September 1984 (1984-09-29) * Zusammenfassung * | 1,3 | |
| A | US 4 851 902 A (TEZUKA ET AL.) 25. Juli 1989 (1989-07-25) * das ganze Dokument * | 1 | RECHERCHIERTE SACHGEBIETE (Int.Cl.7) H01L |
| A | US 5 208 464 A (YONEMOTO ET AL.) 4. Mai 1993 (1993-05-04) * Zusammenfassung * | 1,2 | |
| A | WO 01 89765 A (APPLIED MATERIALS) 29. November 2001 (2001-11-29) * Abbildung 5 * * Seite 12, Zeile 24 - Seite 13, Zeile 3 * | 1 | |
| A | US 5 926 742 A (THAKUR ET AL.) 20. Juli 1999 (1999-07-20) * Abbildung 3 * * Spalte 5, Zeile 10-41 * | 1 | |

Der vorliegende Recherchenbericht wurde für alle Patentansprüche erstellt

| Recherchenort | Abschlußdatum der Recherche | Prüfer |
|---|---|---|
| DEN HAAG | 16. September 2002 | Oberle, T |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 02 40 5250

16-09-2002

| Im Recherchenbericht angeführtes Patentdokument | Datum der Veröffentlichung | Mitglied(er) der Patentfamilie | | Datum der Veröffentlichung |
|---|---|---|---|---|
| JP 07137886 A | 30-05-1995 | KEINE | | |
| JP 11035152 A | 09-02-1999 | KEINE | | |
| JP 59172731 A | 29-09-1984 | JP | 1905779 C | 24-02-1995 |
| | | JP | 4039227 B | 26-06-1992 |
| US 4851902 A | 25-07-1989 | JP | 1799330 C | 12-11-1993 |
| | | JP | 5008473 B | 02-02-1993 |
| | | JP | 63193277 A | 10-08-1988 |
| | | JP | 63193539 A | 10-08-1988 |
| | | JP | 2085779 C | 23-08-1996 |
| | | JP | 7119706 B | 20-12-1995 |
| | | JP | 63247649 A | 14-10-1988 |
| | | GB | 2197948 A ,B | 02-06-1988 |
| | | SG | 31393 G | 21-05-1993 |
| US 5208464 A | 04-05-1993 | JP | 2794486 B2 | 03-09-1998 |
| | | JP | 4206745 A | 28-07-1992 |
| | | KR | 9513736 B1 | 15-11-1995 |
| WO 0189765 A | 29-11-2001 | WO | 0189765 A1 | 29-11-2001 |
| | | US | 2002077031 A1 | 20-06-2002 |
| | | US | 2002055192 A1 | 09-05-2002 |
| US 5926742 A | 20-07-1999 | US | 5851929 A | 22-12-1998 |

EPO FORM P0461